# EUROPEAN PATENT SPECIFICATION

(11) **EP 0 929 909 B1**
(45) Date of publication and mention of the grant of the patent: **27.09.2006**
(21) Application number: 98910950.9
(22) Date of filing: 16.04.1998
(51) Int. Cl.: H01L 21/3205, H01L 21/3213, H01L 21/324, H01L 23/52

(54) **METHOD OF MANUFACTURING A SEMICONDUCTOR DEVICE**
VERFAHREN ZUR HERSTELLUNG EINER HALBLEITER-ANORDNUNG
PROCEDE DE FABRICATION DE DISPOSITIF A SEMI-CONDUCTEUR

(30) Priority: 06.06.1997 EP 97201720
(43) Date of publication of application: 21.07.1999
(60) Divisional application: 06100794.4
(73) Proprietor: Koninklijke Philips Electronics N.V., 5621 BA Eindhoven (NL)
(72) Inventor: KORDIC, Srdjan, NL-5656 AA Eindhoven (NL); KNOTTER, Dirk, Maarten, NL-5656 AA Eindhoven (NL); MUTSAERS, Cornelis, Adrianus, Henricus, Antonius, NL-5656 AA Eindhoven (NL)
(74) Representative: Duijvestijn, Adrianus Johannes
(86) International application number: PCT/IB1998/000567
(87) International publication number: WO 1998/056038

(56) References cited:
- EP-A- 0 659 858
- US-A- 4 944 836
- US-A- 5 256 565
- US-A- 5 670 425
- PATENT ABSTRACTS OF JAPAN; & JP,A,10 050 710 (MATSUSHITA ELECTRIC IND CO LTD) 20 February 1998.
- DERWENT ABSTRACT, No. 97-383318/35, Week 9735; & JP,A,09 167 770 (HYNDAI ELECTRONICS IND CO LTD) 24 June 1997.
- PATENT ABSTRACTS OF JAPAN; JP,A,02 065 229 (NEC CORP) 5 March 1990.
- PATENT ABSTRACTS OF JAPAN; & JP,A,05 121 407 (TOSHIBA CORP) 18 May 1993.

## Description

The invention relates to a method of manufacturing a semiconductor device with a semiconductor body comprising a semiconductor substrate and at least two semiconductor regions which together form a pn junction, by which method the semiconductor body is covered with an electrically insulating layer, a recess is formed in the insulating layer, and a conductive material, which comprises a first material and a second material, is provided in the recess in the insulating layer.

Such a method is used, for example, for planarizing an IC (= Integrated Circuit), for example by chemical-mechanical polishing, which IC is provided with conductor tracks or with a conductive connection between such tracks or between a conductor track and a semiconductor region by means of a so-called Damascene process. The ever smaller dimensions of the components of an IC bring with them requirements which such a method is capable of meeting. The use of a conductive material composed of two different materials serves, for example, to make the mechanical stresses in the resulting structure as low as possible.

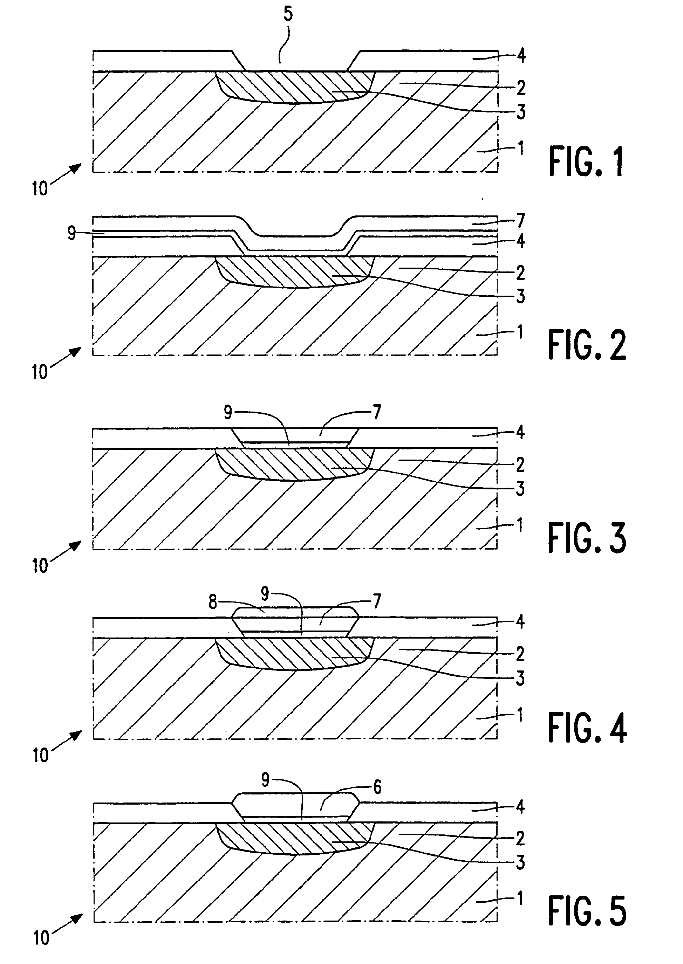

Such a method is known from USP (United States Patent) no. 4,944,836. This describes a method (see, for example, Fig. 3A and column 6, lines 24 to 53) whereby a semiconductor body is formed by a silicon substrate which comprises a first semiconductor region and in which a diffused semiconductor region is present which comprises a second semiconductor region, for example for the purpose of forming a pn junction. An insulating layer of sputtered silicon dioxide is provided on the semiconductor body, and an opening (or a recess as in Fig. 2A) is provided in this layer. The opening is filled up with a conductive material which comprises two materials, copper and aluminum in this case. A sufficiently thick layer of copper and aluminum is for this purpose provided over the insulating layer and the opening. Then the copper and aluminum layer is ground back by means of chemical-mechanical polishing to the extent that no material is present any more outside the opening on the insulating layer, while the opening remains exactly filled with the material comprising an alloy of copper and aluminum. A conductor track or a so-called via is formed in this manner. The conductive material comprising copper and aluminum achieves that the resulting structure has very few mechanical stresses, which strongly benefits the reliability and the longevity of the resulting IC.

A disadvantage of the known method is that the known method results in an insufficiently plane recess after the chemical-mechanical polishing, which is not evenly filled up with conductive material. This leads to problems, such as a low yield, especially if, as is often the case, further conductive or insulating layers are to be provided over the filled opening. A previously formed conductor track may even be locally interrupted in the worst case.

It is an object of the present invention to provide a method of the kind mentioned in the opening paragraph which is not subject to the above disadvantage.

According to the invention, a method of the kind mentioned in the opening paragraph is for this purpose characterized in that first a first layer of the first material is provided over the insulating layer and the recess therein, then part of the first layer of the first material is removed by means of a chemical etchant, then a second layer of the second material which is thin compared with the first layer is provided over the remaining portion of the first layer of the first material, whereupon the remaining portion of the first layer of the first material and the second, comparatively thin layer of the second material are mixed with one another by means of a thermal treatment. The invention is based first of all on the recognition that the homogeneous and controlled removal of a conductive material composed of several materials by means of a chemical etchant, especially if this takes place by chemical-mechanical polishing thereof, is usually more difficult than the removal of a (conductive) material which comprises only a single component. Thus a copper-aluminum alloy, and more in general an alloy of two metals which occupy different positions in the electrochemical series, is more corrosive than a copper layer or aluminum layer, owing to the formation of an electrochemical cell. It should be noted in this connection that the distribution of the constituent materials is not always very homogeneous. Now if a comparatively thick layer of the first material is first provided and is subsequently chemically removed, more in particular chemically-mechanically removed for a (major) portion, the above problem may be reduced or even avoided. When subsequently a comparatively thin layer of the second material is provided, the planeness obtained after the chemical-mechanical polishing step is not or at least substantially not affected any more. A subsequent thermal treatment eventually leads to the creation of a conductive material of the most desirable composition in the opening of the insulating layer.

In a preferred embodiment of a method according to the invention, aluminum is chosen for the first material and copper is chosen for the second material. In that case a thick aluminum layer is provided first, whereupon the chemical-mechanical polishing takes place, and then a thin copper layer is provided which is mixed with the remaining aluminum by baking. The choice of aluminum as the first material is based on the fact that the eventual copper-aluminum alloy need contain only comparatively little copper, for example between 0.1 and 50% by weight. This renders it possible to realize the desired final composition by mixing a comparatively thick aluminum layer with a comparatively thin copper layer. In addition, the use of a chemical etchant such as dilute nitric acid and a chemical-mechanical removal process based on this etchant, where a slurry containing silicon dioxide and aluminum oxide particles is used, yields excellent results in combination with aluminum as to the planeness and smoothness of the resulting structure after the chemical-mechanical polishing process. The fact that the copper is provided last also has the important advantage that the copper remains as far removed from the semiconductor regions as possible. Any copper atoms penetrating therein are highly detrimental to a good operation of these regions.

A method according to the invention preferably utilizes chemical-mechanical polishing for removing a (major) portion of the first layer. Preferably, the thickness of the first layer of the first material is chosen such that the recess or opening in the insulating layer is at least fully filled up, and the portion of the first layer of the first material which is removed again is so great that the first layer of the first material is entirely removed from outside the recess in the insulating layer. This method leads to the creation of, for example, a well-defined conductor track or via. The second, comparatively thin layer of the second material is preferably provided selectively only in those locations where the remaining portion of the first layer of the first material is present. Well-defined dimensions of conductor tracks or vias are also promoted thereby. This also has the important advantage, if the second layer comprises, for example, copper, that the risk of copper contamination of the semiconductor regions is minimized.

In a preferred embodiment of a method according to the invention, a cleaning step is added before the step of providing the second layer and/or after the step of mixing of the first layer and second layer, for which cleaning step an aqueous solution of ozone and the mineral acid of hydrogen fluoride is chosen as a cleaning agent. Such a cleaning step gives good cleaning results after a chemical-mechanical polishing process. Such a cleaning process is known, for example, from European patent EP 0.731.495 published on 11-09-1996. Owing to the higher reactivity with respect to the usual cleaning agent as mentioned above, however, an inadmissible roughening and even removal of the material comprising aluminum takes place also in this case. The addition to the cleaning agent of another mineral acid which is incapable of oxidation by ozone renders it possible to adjust the acidity thereofto such an extent that the conductive layer of the material comprising aluminum is passivated during the cleaning process. Such a method is found to give excellent results not only here, but also in cleaning in an earlier stage of the manufacture of such a conductive layer, i.e. after the aluminum layer required for it has been formed or after the thickness thereof has been reduced by chemical-mechanical polishing.

A suitable acidity of the cleaning agent is found to be one which lies in the pH range of between 2 and 7, while sulphuric acid, nitric acid, phosphoric acid, and boric acid are found to be the most suitable mineral acids. A substance may also advantageously be added to the cleaning agent which reduces the surface tension thereof. The addition of ultrasonic or preferably megasonic energy to the semiconductor body during the cleaning process also contributes to an excellent cleaning result.

The invention will now be explained in more detail with reference to an embodiment and the accompanying drawing, in which

Figs. 1 to 5 are cross-sectional views taken perpendicular to the thickness direction of a semiconductor device manufactured by an embodiment of a method according to the invention in consecutive stages of manufacture.

The Figures are diagrammatic and not true to scale, the dimensions in the thickness direction being particularly exaggerated for greater clarity. Corresponding components have been given the same reference numerals in the various Figures as a rule. Semiconductor regions of the same conductivity type have been hatched in the same direction as a rule.

Figs. 1 to 5 are cross-sectional views taken perpendicular to the thickness direction of a semiconductor device manufactured by an embodiment of a method according to the invention in consecutive stages of manufacture. The formation of the semiconductor body 10 of the semiconductor device, an IC in this case, starts with an n-type silicon substrate 1 (see Fig. 1) which is provided with an insulating layer 4 of silicon dioxide having a thickness of 1 µm by means of thermal oxidation. A recess 5, here a through opening 5, is formed in this layer by means of photolithography and etching. A p-type semiconductor region 3 is formed in the semiconductor body 10, for example by means of ion implantation, forming a pn junction together with the portion 2 of the substrate 1 lying outside it, which pn junction forms part of a MOS (= Metal Oxide Semiconductor) transistor, for example as the source. A conductive material 6 (see Fig. 5) is then provided in the opening 5 of the insulating layer 4, comprising two different materials, two metals in this case, i.e. aluminum (90% by weight) and copper (10% by weight). In the present example, a so-called barrier layer 9, comprising titanium nitride here, is present between the semiconductor region 3 to be contacted and the conductive material 6, where this conductive material 6 forms a contact.

The formation of the conductive material 6 takes place as follows in accordance with the invention: first (see Fig. 2) a first layer 7 of the first material, i.e. aluminum in this case, is provided over the insulating layer 4 and the opening therein, for example by means of CVD (= Chemical Vapor Deposition). The thickness chosen for the first layer 7 is 2 µm in this example, so that the first layer 7 is thicker than the insulating layer 4. Before the first layer 7 is provided, a thin barrier layer 9 of titaniumnitride is provided in this example, but this is immaterial to the invention. Then (see Fig. 3), according to the invention, a portion of the first layer 7 of aluminum is removed again chemically by means of a chemical etchant, here a dilute aqueous solution containing nitric acid, indeed, in a chemical-mechanical manner because a polishing disc and a slurry of silicon dioxide and aluminum oxide particles are also used during this. So much is removed of the first layer 7 in this example that only the opening 5 in the insulating layer 4 remains covered and filled with aluminum, while no aluminum is present any more outside the opening 5 on the insulating layer 4. The resulting thickness of the insulating layer 4 is then approximately 0.5 µm. Thanks to the use of the slurry mentioned above, the surface of the semiconductor body 10 and in particular of the aluminum present inside the opening 5 has a particularly planar and smooth structure. In addition, the aluminum 7 and the insulating layer 4 are excellently coplanar. Then (see Fig. 4) a second layer 8 of the second material, i.e. copper in this case, is provided on the first layer 7, by means of selective CVD in this case. The thickness chosen for the second layer 8 is approximately 0.015 µm, which is a small thickness compared with that of the first layer 7. This means that the material 7, 8 present in the opening 5 of the insulating layer 4 is still substantially coplanar with the insulating layer 4. The planeness and smoothness of the second layer 8 of copper is also excellent. In the present example, the second layer 8 is selectively deposited, which means that the thin layer 8 is not formed on the insulating layer 4. This has the advantage, not only of simplicity, but also that the risk of the semiconductor body 10 becoming contaminated with copper is small. Finally, the two materials 7, 8 now present in the opening 5 are intermixed by means of a suitable thermal treatment. The desired aluminum-copper alloy is formed inside the opening 5 thereby in this example. A suitable thermal treatment comprises, for example, baking of the semiconductor body 10 at a temperature of between 300 and 550 °C, in this case 450 °C.

A semiconductor device with a conductor track or via 6 having excellent properties is obtained by this method. On the one hand, the device obtained suffers no or at least substantially no electromigration thanks to the use of the aluminum-copper alloy mentioned above, and is accordingly reliable and has a long life. On the other hand, these last two properties and the yield of the process are additionally strongly improved because the excellent surface quality of the deposited aluminum layer 7 and the deposited copper layer 8 is retained, also after the chemical-mechanical polishing process and after the baking process in which said layers 7, 8 are intermixed. The coplanarity of the conductive material 6 and the insulating layer 4 is excellent, so that the subsequent application of a further insulating or conductive layer will also result in the particularly plane and smooth surface which is necessary for further photolithographic processes. The invention is of particular importance in view of the very small dimensions which a via 6 must have in present-day ICs, for example 0.2 x 0.2 µm². The importance of the invention will increase with a further decrease in these dimensions.

The semiconductor body 10 may be excellently cleaned with a cleaning agent comprising an aqueous solution of ozone and the mineral acid of hydrogen fluoride both after the first layer 7 of aluminum has been provided and has been bulk-reduced by grinding and after the selective application of the second, thin layer 8 of copper and mixing thereof with the first layer 7 of aluminum. According to the invention, the best results are obtained as regards the continued planeness and smoothness of a layer 6, 7 comprising aluminum if the cleaning agent is given an acidity by means of a mineral acid other than hydrogen fluoride during cleaning such that the material 6, 7 comprising aluminum is passivated. The reactivity of the material 6, 7 comprising aluminum with respect to the cleaning agent is substantially suppressed thereby, so that said material 6, 7 is not or at least substantially not attacked. In the present example, the other mineral acid chosen is nitric acid, and the acidity chosen corresponds to pH = 4. The best results are obtained when, as in the present example, a surfactant such as soap is also added to the cleaning agent, and ultrasonic or, as in the present example, megasonic energy is supplied to the semiconductor body 10 during the cleaning process.

Further particulars of the semiconductor body 10 have been omitted for the sake of simplicity. These are the metallization of the substrate 1 and any further insulating or conductive layers which may be present above the insulating layer 4 and the conductive material 6 in the opening 5 therein, as well as further pn junctions of diodes or transistors which form part of the relevant IC. The steps necessary for these in a method according to the invention correspond to steps which are usual and will be carried out in a usual manner.

The invention is not limited to the embodiment given since many modifications and variations are possible to those skilled in the art within the scope of the invention. Thus compositions and thicknesses other than those mentioned in the example may be chosen for the various regions or layers. Other metals may be chosen for the first and the second material which are sufficiently far removed from one another in the electrochemical series, such as aluminum and vanadium or titanium. A combination of three or more metals is also possible. As was noted above, it is not necessary for the first and the second material to be both metals. The first material may be chosen to be, for example, polycrystalline or monocrystalline silicon, and the second material, for example, the metal cobalt. Cobalt silicide is then obtained in the thermal treatment.

Alternative techniques, for example sputtering, may be used for providing the first and the second layer. Copper may also be electrolytically provided on aluminum, or electrolessly from the liquid phase. It is also possible for the method according to the invention to be used more than once in the manufacture of semiconductor devices, for example for obtaining a multilayer wiring. The semiconductor regions 2 and 3 in the drawing may then comprise, for example, an insulating layer and a conductor track, respectively.

## Claims

1. A method of manufacturing a semiconductor device with a semiconductor body (10) comprising a semiconductor substrate (1) and at least two semiconductor regions (2, 3) which together form a pn junction, by which method the semiconductor body (10) is covered with an electrically insulating layer (4), a recess (5) is formed in the insulating layer (4), and a conductive material (6), which comprises a first material and a second material, is provided in the recess (5) in the insulating layer (4), **characterized in that** first a first layer (7) of the first material is provided over the insulating layer (4) and the recess (5) therein, then part of the first layer (7) of the first material is removed by means of a chemical etchant, then a second layer (8) of the second material which is thin compared with the first layer (7) is provided over the remaining portion of the first layer (7) of the first material, whereupon the remaining portion of the first layer (7) of the first material and the second, comparatively thin layer (8) of the second material are mixed with one another by means of a thermal treatment.

2. A method as claimed in claim 1, **characterized in that** aluminum is chosen for the first material and copper is chosen for the second material.

3. A method as claimed in claim 1 or 2, **characterized in that** the removal of part of the first layer (7) of the first material is achieved by means of chemical-mechanical polishing.

4. A method as claimed in claim 1, 2 or 3, **characterized in that** the thickness of the first layer (7) of the first material is chosen such that the recess (5) in the insulating layer (4) is at least fully filled up, and the portion of the first layer (7) of the first material which is removed is so great that the first layer (7) of the first material is entirely removed from outside the recess (5) in the insulating layer (4).

5. A method as claimed in claim 1, 2, 3 or 4, **characterized in that** the second, comparatively thin layer (8) of the second material is provided selectively only in those locations where the remaining portion of the first layer (7) of the first material is present.

6. A method as claimed in any one of the preceding claims, **characterized in that** the recess (5) comprises a through opening (5).

7. A method as claimed in claim 2, **characterized in that** a cleaning step is added before the step of providing the second layer (8) and/or after the step of mixing of the first layer (7) and second layer (8), for which cleaning step an aqueous solution of ozone and the mineral acid ofhydrogen fluoride is chosen as cleaning agent, wherein the acidity of the cleaning agent is adjusted through the addition of another mineral acid incapable of oxidation by ozone such that the conductive material comprising aluminum is passivated during the cleaning step.

8. A method as claimed in claim 7, **characterized in that** the pH value of the cleaning agent is chosen to lie between 2 and 7, and that sulphuric acid, nitric acid, phosphoric acid, or boric acid is chosen as said other mineral acid.

9. A method as claimed in claim 7 or 8, **characterized in that** a substance is added to the cleaning agent by means of which the surface tension thereof is reduced, and **in that** ultrasonic, and preferably megasonic energy is supplied to the semiconductor body (10) during the cleaning process.

## Patentansprüche

1. Verfahren zur Herstellung einer Halbleiteranordnung mit einem Halbleiterkörper (10) mit einem Halbleitersubstrat (1) und mindestens zwei Halbleiterbereichen (2, 3), welche zusammen einen pn-Übergang bilden, wonach der Halbleiterkörper (10) mit einer elektrisch leitenden Isolationsschicht (4) versehen, in der Isolationsschicht (4) eine Vertiefung (5) ausgebildet und ein leitendes Material (6), welches aus einem ersten Material und einem zweiten Material besteht, in der Vertiefung (5) der Isolationsschicht (4) vorgesehen wird, **dadurch gekennzeichnet, dass** zuerst eine erste Schicht (7) aus dem ersten Material über der Isolationsschicht (4) und der Vertiefung (5) darin vorgesehen wird, danach ein Teil der ersten Schicht (7) aus dem ersten Material mit Hilfe eines chemischen Ätzmittels entfernt wird, sodann eine zweite Schicht (8) aus dem zweiten Material, welche im Vergleich zu der ersten Schicht (7) dünn ist, über dem verbleibenden Teil der ersten Schicht (7) aus dem ersten Material vorgesehen wird und daraufhin der restliche Teil der ersten Schicht (7) aus dem ersten Material und die zweite, verhältnismäßig dünne Schicht (8) aus dem zweiten Material durch eine thermische Behandlung miteinander gemischt werden.

2. Verfahren nach Anspruch 1, **dadurch gekennzeichnet, dass** als erstes Material Aluminium und als zweites Material Kupfer gewählt wird.

3. Verfahren nach Anspruch 1 oder 2, **dadurch gekennzeichnet, dass** das Entfernen der ersten Schicht (7) aus dem ersten Material durch chemisch-mechanisches Polieren erreicht wird.

4. Verfahren nach Anspruch 1, 2 oder 3, **dadurch gekennzeichnet, dass** die Dicke der ersten Schicht (7) aus dem ersten Material so gewählt wird, dass die Vertiefung (5) in der Isolationsschicht (4) zumindest teilweise gefüllt und der Teil der ersten Schicht (7) aus dem ersten Material, welcher entfernt wird, so groß ist, dass die erste Schicht (7) aus dem ersten Material von außerhalb der Vertiefung (5) in der Isolationsschicht (4) komplett entfernt wird.

5. Verfahren nach Anspruch 1, 2, 3 oder 4, **dadurch gekennzeichnet, dass** die zweite, verhältnismäßig dünne Schicht (8) aus dem zweiten Material nur an solchen Stellen selektiv vorgesehen wird, an denen der restliche Teil der ersten Schicht (7) aus dem ersten Material vorhanden ist.

6. Verfahren nach einem der vorangegangenen Ansprüche, **dadurch gekennzeichnet, dass** die Vertiefung (5) eine Durchgangsöffnung (5) aufweist.

7. Verfahren nach Anspruch 2, **dadurch gekennzeichnet, dass** vor Aufbringen der zweiten Schicht (8) und/oder nach Mischen der ersten Schicht (7) und der zweiten Schicht (8) zusätzlich ein Reinigungsschritt vorgesehen ist, bei welchem eine wässrige Lösung aus Ozon und der Mineralsäure aus Fluorwasserstoffsäure als Reinigungsmittel gewählt wird, wobei der Säuregrad des Reinigungsmittels durch das Hinzufügen einer weiteren Mineralsäure, welche zu einer Oxidation durch Ozon nicht imstande ist, so eingestellt wird, dass das leitende Material, welches Aluminium enthält, während des Reinigungsvorgangs passiviert wird.

8. Verfahren nach Anspruch 7, **dadurch gekennzeichnet, dass** der pH-Wert des Reinigungsmittels so ausgewählt wird, dass er zwischen 2 und 7 liegt, und dass Schwefelsäure, Salpetersäure, Phosphorsäure oder Borsäure als die weitere Mineralsäure ausgewählt wird.

9. Verfahren nach Anspruch 7, **dadurch gekennzeichnet, dass** zu dem Reinigungsmittel eine Substanz hinzugefügt wird, durch welche die Oberflächenspannung reduziert wird, und dass dem Halbleiterkörper (10) während des Reinigungsvorgangs Ultraschall-, vorzugsweise Megaschallenergie, zugeführt wird.

## Revendications

1. Procédé de fabrication d'un dispositif semi-conducteur avec un corps à semi-conducteur (10) comprenant un substrat à semi-conducteur (1) et au moins deux régions à semi-conducteur (2, 3) qui forment ensemble une jonction pn, procédé par lequel le corps à semi-conducteur (10) est couvert avec une couche isolante électriquement (4), une entaille (5) est formée dans la couche isolante (4), et un matériau conducteur (6), qui comprend un premier matériau et un second matériau, est fourni dans l'entaille (5) dans la couche isolante (4), **caractérisé en ce que** d'abord une premier couche (7) du premier matériau est fournie au-dessus de la couche isolante (4) et de l'entaille (5) dans celle-ci, ensuite une partie de la première couche (7) du premier matériau est enlevée au moyen d'un agent de gravure chimique, ensuite une seconde couche (8) du second matériau qui est fine comparée à la première couche (7) est fournie au-dessus de la portion restante de la première couche (7) du premier matériau, sur laquelle la portion restante de la première couche (7) du premier matériau et la seconde couche, comparativement fine, (8) du second matériau sont mélangées l'une avec l'autre au moyen d'un traitement thermique.

2. Procédé selon la revendication 1, **caractérisé en ce que** l'aluminium est choisi pour le premier matériau et le cuivre est choisi pour le second matériau.

3. Procédé selon la revendication 1 ou 2, **caractérisé en ce que** l'enlèvement d'une partie de la première couche (7) du premier matériau est réalisé au moyen d'un polissage chimique-mécanique.

4. Procédé selon la revendication 1, 2 ou 3, **caractérisé en ce que** l'épaisseur de la première couche (7) du premier matériau est choisie de sorte que l'entaille (5) dans la couche isolante (4) est au moins totalement remplie, et la portion de la première couche (7) du premier matériau qui est enlevée est si grande que la première couche (7) du premier matériau est entièrement enlevée de l'extérieur de l'entaille (5) dans la couche isolante (4).

5. Procédé selon la revendication 1, 2, 3 ou 4, **caractérisé en ce que** la seconde couche, comparativement fine, (8) du second matériau est fournie sélectivement uniquement dans ces emplacements où la portion restante de la première couche (7) du premier matériau est présente.

6. Procédé selon l'une quelconque des revendications précédentes, **caractérisé en ce que** l'entaille (5) comprend une ouverture traversant (5).

7. Procédé selon la revendication 2, **caractérisé en ce qu'**une étape de nettoyage est ajoutée avant l'étape de fourniture de la seconde couche (8) et/ou après l'étape de mélange de la première couche (7) et de la seconde couche (8), étape de nettoyage pour laquelle une solution aqueuse d'ozone et de l'acide minéral de fluorure d'hydrogène est choisie comme agent nettoyant, l'acidité de l'agent nettoyant étant ajustée par l'ajout d'un autre acide minéral incapable de s'oxyder par l'ozone de sorte que le matériau conducteur comprenant l'aluminium est passivé durant l'étape de nettoyage.

8. Procédé selon la revendication 7, **caractérisé en ce que** la valeur de pH de l'agent nettoyant est choisie pour se situer entre 2 et 7, et que l'acide sulfurique, l'acide nitrique, l'acide phosphorique ou l'acide borique est choisi comme ledit autre acide minéral.

9. Procédé selon la revendication 7 ou 8, **caractérisé en ce qu'**une substance est ajoutée à l'agent nettoyant au moyen de laquelle la tension de surface de celui-ci est réduite, et **en ce que** de l'énergie ultrasonique et de préférence, mégasonique est fournie au corps à semi-conducteur (10) durant le processus de nettoyage.
